# EUROPÄISCHE PATENTSCHRIFT

(11) **EP 1 741 135 B1**
(45) Veröffentlichungstag und Bekanntmachung des Hinweises auf die Patenterteilung: **21.05.2008**
(21) Anmeldenummer: 05730746.4
(22) Anmeldetag: 14.04.2005
(51) Int. Cl.: H01L 23/31

(54) **Verfahren zur Herstellung eines Chipmoduls**
Method for the production of a chip module
Procédé de fabrication d'un module à puce

(30) Priorität: 28.04.2004 DE 102004020877
(43) Veröffentlichungstag der Anmeldung: 10.01.2007
(73) Patentinhaber: Fraunhofer-Gesellschaft zur Förderung der angewandten Forschung e.V., 80686 München (DE)
(72) Erfinder: WEGERER, Gabriele, 80339 München (DE); ANSORGE, Frank, 81245 München (DE); KALLMAYER, Christine, 14612 Falkensee (DE); REBHOLZ, Christian, 86859 Igling (DE)
(74) Vertreter: Schenk, Markus
(86) Internationale Anmeldenummer: PCT/EP2005/003958
(87) Internationale Veröffentlichungsnummer: WO 2005/109496

(56) Entgegenhaltungen:
- US-A- 5 236 873
- US-A- 5 264 061
- US-A1- 2001 036 718
- US-A1- 2002 117 701
- US-A1- 2004 046 250

## Beschreibung

Die vorliegende Erfindung bezieht sich auf ein Verfahren zur Herstellung eines Chipmoduls.

Immer häufiger werden in miniaturisierten Geräten, wie beispielsweise PDAs oder Mobiltelefonen, ungehäuste Chips bzw. Bare-Dices oder Nacktchips eingesetzt. Ein Vorteil eines Einsatzes dieser Bare-Dices ist, daß sie geringere geometrische Abmessungen als gehäuste Chips aufweisen. Gleichzeitig stellt ein zunehmend schnellebigeres Verhalten von Verbrauchern, die diese Geräte kaufen, eine Anforderung, eine Entwicklungszeit von den miniaturisierten Geräten, wie beispielsweise PDAs oder Mobiltelefonen, zu reduzieren.

Um ein miniaturisiertes Gerät zu entwickeln, ist häufig eine Anfertigung eines Prototyps erforderlich. Hierbei wird häufig an die Bare-Dices die Anforderung gestellt, die Kontakte zur Verbindung mit einer Leiterplatte in verschiedenen Ausführungsvarianten eines Prototyps an verschiedenen Positionen aufzuweisen.

Hierbei gilt, daß bei portablen elektrischen Geräten wie Handys oder Notebooks die ICs immer kleiner werden und gleichzeitig dazu immer mehr Funktionen übernehmen. Ein Chip für ein Standardbondverfahren hat beispielsweise die Anschlußpads, die heute bei einer Fläche von etwa 75 µm x 75 µm liegen, peripher an den Begrenzungsflächen des Chips angeordnet; somit ist die Anzahl der Pins beschränkt oder in Extremfällen ist das Design padbestimmt, d. h. wegen der Anzahl der Pads wird mehr Chipfläche benötigt, als für die eigentliche Funktion nötig wäre. Durch eine sogenannte Umverdrahtung können die Anschlußpads von der Randzone in die Mitte an jede beliebige Stelle der Chipoberfläche verteilt werden, wodurch sich wesentlich mehr Anschlußmöglichkeiten ergeben.

Außerdem besteht aufgrund der Flip-Chip-Auslegung, wenn die Pads nicht am Chiprand plaziert sind, die Möglichkeit, das Signal direkt an der Stelle, wo es erzeugt wird, aus dem Chip zu führen.

Realisiert wird dieses Verfahren schon bei dem Aufbringen der sogenannten C4-Solder-Bumps, wobei C4 für eine Verbindungstechnologie steht, die einem sogenannten Controlled-Collapse-Chip-Connection entspricht, bei einem Flip Chip, da sich durch die sich ergebenden extrem kurzen Wege dieser Chip besonders für hochfrequente Anwendungen eignet.

Die Umverdrahtung, die das Wegführen eines Kontakts durch das Aufbringen einer elektrisch leitenden Schicht beinhaltet, erfordert aber in diesem Fall eine sehr aufwendige Technik, die beispielsweise Verfahren aus der Dünnfilmtechnik einsetzen. Das Verfahren kommt aus der Chipherstellung selbst.

In einem Ausführungsbeispiel gemäß dem Stand der Technik erfolgt das Umverdrahten eines Bare-Dices mittels in einer Chipherstellung eingesetzter Fertigungsverfahren.

Dabei wird vorzugsweise eine sogenannte Lithographie eingesetzt. Hierbei wird auf einen bereits fertig bearbeiteten Wafer, der für eine Vielzahl von ungehäusten Chips oder Bare-Dices vorgesehen ist, bzw. aus welchem durch Vereinzeln bzw. Dicen eine Vielzahl von ungehäusten Chips oder Bare Dices erhalten werden soll, ein Photolack aufgetragen. Über eine lithographische Maske, die ein Abbild des Chipdesigns enthält, wird ein lichtempfindlicher Photolack mit Licht, in der Regel im UV-Lichtbereich, belichtet. Nach einer chemischen Entwicklung wird dann bei einem Positiv-Photolack ein belichteter von einer Maske nicht abgedeckter Teil des Photolacks entfernt. Anschließend kann mit einer Säure, die einen Photolack nicht angreift, eine mit einer Maske vorgegebene entsprechende Struktur aus dem Untermaterial unterhalb der Photomaske herausgeätzt werden. Umverdrahtungen werden anschließend Schicht für Schicht gefertigt, indem Belichtungs- und selektive Abtragungs- bzw. Auftragungsvorgänge mehrfach wiederholt werden. Dabei erfordert jede Schicht eine eigene lithographische Maske, die wiederum ausgefeilte Herstellungstechniken erfordert.

So werden Löcher und Gräben erzeugt, die dann galvanisch mit einem Metall - vorzugsweise Kupfer oder Gold - gefüllt werden. Vorzugsweise werden Löcher nur im Lack erzeugt, der ja dann wieder entfernt wird, während Löcher für beispielsweise Vias auch im Dielektrikum erzeugt werden können. Danach kann ein umverdrahteter Wafer, der für eine Ansammlung an Bare-Dices vorgesehen ist, mit sogenannten Lothöckern bzw. Bumps versehen werden. Dieses Versehen des Wafers mit Lothöckern kann beispielsweise galvanisch durchgeführt werden oder, falls große Mittenabstände bestehen - wobei unter großen Mittenabständen vorzugsweise Distanzen größer 200 µm verstanden werden - mittels kostengünstigerer Schablonendruckprozesse.

Bei allen in obigem Ausführungsbeispiel gemäß dem Stand der Technik eingesetzten Prozessen handelt es sich um sogenannte Wafer-Ebene-Technologien, die dadurch gekennzeichnet sind, daß sie nur auf einem vollständigen Wafer durchgeführt werden können, also in einem Zustand, bei dem der Wafer noch nicht in ungehäuste Dices vereinzelt worden ist.

Ein Wafer umfaßt damit eine Anzahl an Prototypen, die alle eine identische Konfiguration an Kontakten auf dem Chip aufweisen. Die Anzahl der gefertigten identischen Prototypen ist damit stets ein Vielfaches einer Anzahl der Prototypen, die ein einzelner Wafer umfaßt. Somit ist das Verfahren zur Herstellung von Prototypen mit umverdrahteten Kontakten unflexibel.

Nachteilhaft ist auch, daß eine Mehrzahl an Prozeßschritten erforderlich ist, um einen Bare-Dice mit den umverdrahteten Kontakten herzustellen. Dadurch ist das Herstellungsverfahren aufwendig. Die Anzahl an Prozeßschritten führt auch dazu, daß die Herstellung eines Chips mit den umverdrahteten Kontakten eine längere Fertigungszeit erfordert. Dies wirkt sich ungünstig auf einen Entwicklungszyklus eines neuen Geräts aus, das diese ungehäusten Chips mit umverdrahteten Kontakten zu Entwicklungszwecken einsetzt. Darüber hinaus erfordert jede Konfiguration eines Bare-Dices mit umverdrahteten Kontakten einen neuen Maskensatz. Da eine Fertigung eines neuen Maskensatzes sehr kostenintensiv ist, steht dies einer Forderung nach geringen Entwicklungskosten entgegen.

Zugleich ist eine Herstellung von einer geringen Anzahl oder einem einzigen Wafer an einem Front-End-Standort, an dem typischerweise eine Massenfertigung von Wafern durchgeführt wird, aufgrund dort ablaufender Herstellungsprozesse schwierig implementierbar. Auch dies steht einer kostengünstigen Fertigung von Prototypen umverdrahteter Chips entgegen, was wiederum zu einer Erhöhung der Entwicklungskosten führt.

US-2004/0046250 beschreibt ein Verfahren zur Herstellung eines Chipmoduls nach den Stand der Technik.

US-2001/0036718 A1 lehrt ein Stereolithographie-Verfahren zum Verarbeiten von Halbleiterbauelementen. Hierbei wird ein Halbleiterbauelement bzw. ein Substrat auf einer'Plattform angeordnet. Das Substrat kann über stereolithographisch hergestellte Stützen auf der Plattform fixiert werden, um eine seitliche Bewegung des Substrats zu verhindern. Eine Materialschicht wird auf dem auf der Plattform angeordneten Substrat mittels eines Stereolithographie-Verfahrens gebildet.

Auf einem Halbleiterbauelement mit Bondpads wird so auf der aktiven Oberfläche des Halbleiterbauelements eine dielektrische Schicht aufgebracht, auf der anschließend leitende Elemente angeordnet werden, die mit den Bondpads elektrisch verbunden sind. Die dielektrische Schicht isoliert die sich lateral erstreckenden Bereiche der leitenden Elemente. Auf den leitenden Elementen ist wiederum eine schützende Schicht aufgebracht, wobei die leitenden Elemente Kontakte aufweisen, die sich durch die schützende Schicht hindurch erstrecken. Die Kontakte umfassen dabei leitende Strukturen, wie z. B. Solder Bumps.

Die leitenden Elemente, die leitenden Strukturen, die dielektrische Schicht und die schützende Schicht werden dabei mittels Stereolithographie-Verfahren erzeugt.

US 5,264,061 A lehrt ein Verfahren eine 3-dimensionale Schaltungsplatine zu bilden. Ein Substrat für die 3-dimensionale Schaltungsplatine wird mittels einer Stereolithographie-Technik erzeugt. Auf dem mit dem Stereolithographie-Verfahren hergestellten Substrat wird anschließend eine leitende Schaltungsstruktur gebildet. Das Substrat wird in einem weiteren Schritt in die gewünschte 3-dimensionale Form umgeformt.

Der vorliegenden Erfindung liegt die Aufgabe zugrunde, ein Verfahren zur Herstellung eines Chipmoduls mit einem Ersatzkontakt zu schaffen, wobei das Versehen des Ersatzkontakts einfacher erzielbar ist.

Diese Aufgabe wird durch ein Verfahren gemäß Anspruch 1 gelöst.

Das Verfahren schafft ein Chipmodul mit einem Chip und einem Chipkontakt, einer isolierenden Struktur, die zumindest teilweise den Chip und den Chipkontakt bedeckt, einem Ersatzkontakt an einer Außenoberfläche der isolierenden Struktur und einer Leiterbahn zum elektrischen Verbinden des Chipkontakts mit dem Ersatzkontakt.

Darüber hinaus schafft die vorliegende Erfindung ein Verfahren zur Herstellung eines Chipmoduls, das folgende Schritte, nämlich ein Bereitstellen eines Chips mit einem Chipkontakt und ein Erzeugen einer isolierenden Struktur, so daß die isolierende Struktur zumindest teilweise den Chip und den Chipkontakt bedeckt, und so daß ein Ersatzkontakt an der Außenoberfläche der isolierenden Struktur durch eine Leiterbahn mit dem Chipkontakt elektrisch leitend verbunden ist, umfaßt.

Der vorliegenden Erfindung liegt die Erkenntnis zugrunde, daß ein Ersatzkontakt an einer Außenoberfläche einer isolierenden Struktur, die zumindest teilweise einen Chip und einen Chipkontakt umgibt, über eine Leiterbahn mit dem Chipkontakt elektrisch leitend verbunden werden kann, wobei die Position des Ersatzkontakts für jedes hergestellte Chipmodul neu festgelegt werden kann.

Das Chipmodul kann gemäß einem Ausführungsbeispiel der vorliegenden Erfindung in einem einfachen Fertigungsverfahren hergestellt werden, bei dem beispielsweise eine stereolithographisch bearbeitete Kunstharzvorrichtung verwendet wird. Da für einen neuen Prototyp kein neuer Maskensatz herzustellen ist, ist eine Fertigungszeit für ein Chipmodul gemäß der vorliegenden Erfindung verkürzt. Diese verkürzte Fertigungszeit führt zu einer verringerten Entwicklungszeit eines neuen Geräts, das die Chipmodule gemäß der vorliegenden Erfindung zu Testzwecken einsetzt, und damit zu einer rascheren Vermarktbarkeit eines neu zu entwickelnden Geräts. Zudem ist es, da Chips im vereinzelten Zustand umverdrahtbar sind, möglich, kundenspezifische Wünsche in Bezug auf die Kontaktierungsanordnung nach der Herstellung einer großen und damit kostengünstigen evetuell vorab hergestellten Charge von ungehäusten Chips zu erfüllen.

Ein Erzeugen eines umverdrahteten Prototypens, ohne daß dafür ein neuer Maskensatz herzustellen ist, führt auch dazu, daß Entwicklungskosten für ein Anfertigen einer Serie von unterschiedlichen Prototypen gesenkt werden können.

Zusätzlich kann eine Position des Ersatzkontakts auf der isolierenden Struktur von Chipmodul zu Chipmodul variiert werden, sie ist also nicht für eine Anzahl von auf einem Wafer gefertigter ungehäuster Chips identisch. Dies ermöglicht eine größere Flexibilität bei einer Konfiguration von Prototypen und bietet einem Unternehmen die Gelegenheit, unterschiedliche Konfigurationen zu Testzwecken zu fertigen und anschließend in Geräten zu vermessen.

Da eine größere Anzahl an Chips mit Chipkontakten, die identisch auf dem Chip positioniert sind, gefertigt werden kann, ist die Fertigung dieser noch weiter zu verarbeitenden kundenspezifischen Chips kostengünstiger an einem Front-End-Standort, der auf eine Massenfertigung ausgelegt ist, implementierbar. Die Position des Ersatzkontakts und damit eine Konfiguration einer Verbindung zwischen einem Träger und einem bare dice bzw. ungehäusten Chip ist dann durch eine Anordnung eines Ersatzkontakts in dem Chipmodul festlegbar. Hierdurch verringern sich auch Kosten für in einem Entwicklungsprozeß angefertigte Prototypen.

Bevorzugte Ausführungsbeispiele der vorliegenden Erfindung werden nachfolgend Bezug nehmend auf die beiliegenden Zeichnungen näher erläutert. Es zeigen:

| | |
|---|---|
| Fig. 1a | eine Querschnittseitenansicht eines Chipmoduls gemäß der vorliegenden Erfindung; |
| Fig. 1b | eine schematische Teildraufsicht auf das Chipmodul aus Fig. 1a; und |
| Fig. 2a | eine Querschnittsseitenansicht des Chipmoduls von |

| | |
|---|---|
| -1 | Fig. 1 nach aufeinander folgenden Prozessschritten eines Herstellungsverfahrens für das Chipmodul aus Fig. 1a gemäß einem Ausführungsbeispiel der vorliegenden Erfindung. |

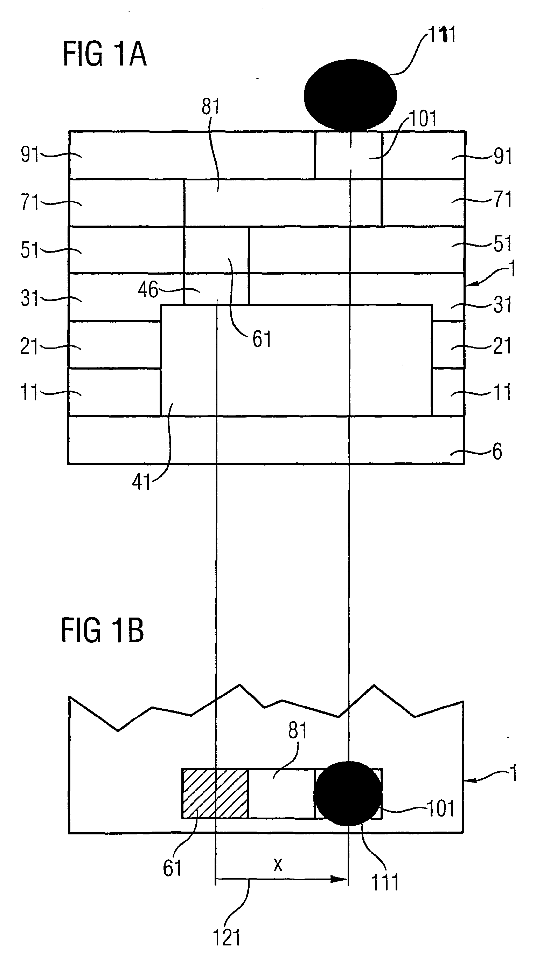

Fig. 1a zeigt einen Aufbau eines Chipmoduls 1. Das Chipmodul 1 umfaßt eine aus Kunstharzschichten 6, 11, 21, 31, 51, 71, 91 gebildete isolierende Struktur, einen Chip 41, einen Chipkontakt 46, eine durch einen Leiterbahnkontakt 61, eine Leiterbahn 81, gebildete elektrische Leiterbahnverbindung, ein Leiterbahnkontaktfenster 101 und einen Solder-Bump bzw. Kontakt-Bump bzw. Lötmittelhöcker bzw. Kontakthöcker 111. Die Kunstharzschichten 6, 11, 21, 31 bilden eine Ausnehmung bzw. einen Hohlraum, in der bzw. in dem der ungehäuste Chip 41 angeordnet ist. In einem Loch der vierten Kunstharzschicht 31 ist der Chipkontakt 46 angeordnet. In einer darüberliegenden fünften Kunstharzschicht 51 ist ebenfalls ein Loch eingebracht, in dem sich der Leiterbahnkontakt 61 befindet, wobei der Leiterbahnkontakt 61 mit dem Chipkontakt 46 verbunden ist. Vorzugsweise besteht die Verbindung zwischen dem Leiterbahnkontakt 61 und dem Chipkontakt 46 in einer elektrischen oder mechanischen Verbindung des Leiterbahnkontakts 61 und des Chipkontakts 46. Eine darüberliegende sechste Kunstharzschicht 71 weist wiederum eine Ausnehmung auf, in der die Leiterbahn 81 angeordnet ist, die an den Leiterbahnkontakt 61 angrenzt und mit demselben verbunden ist. In einer weiteren darüberliegenden siebten Kunstharzschicht 91 ist in einem Loch das Leiterbahnkontaktfenster 101 eingebracht. Dieses Leiterbahnkontaktfenster 101 ist mit der Leiterbahn 81 elektrisch leitend und mechanisch verbunden. Auf dem Leiterbahnkontaktfenster 101 sitzt ein Solder-Bump 111.

Durch eine Länge, eine Richtung und eine Form der Leiterbahn 81 läßt sich die Position des Leiterbahnkontaktfensters 101 und damit auch des daraufsitzenden Solder-Bumps 111 relativ zu dem Leiterbahnkontakt 61 und damit auch zu dem Chipkontakt 46 verändern. In anderen Worten entscheidet die geometrische Konfiguration der Leiterbahn 81 und der Öffnung 101 über die Position des Solder-Bumps 111, unabhängig von einer Position .des Chipkontakts 46 auf der Außenoberfläche des Chips 41, wo der Chipkontakt 46 stets an derselben Stelle auf Chips der selben Sorte aufgebracht sein kann, auch wenn unterschiedliche Anschlusskonfigurationen erwünscht sind.

Somit lassen sich Chipmodule 1 herstellen, bei denen der ungehäuste Chip 41 und der Chipkontakt 46 identisch ausgeführt und positioniert sind, die sich jedoch in der Position des mit dem Chipkontakt 46 elektrisch leitend verbundenen Solder-Bumps 111 unterscheiden, der somit eine Art Ersatzkontakt bildet. In dem in Fig. 1 gezeigten Zustand wird der ungehäuste Chip 41 durch die isolierende Struktur 6-91 umverdrahtet.

Fig. 1b zeigt eine Draufsicht auf das Chipmodul 1 von Fig. 1a, in der jedoch Elemente dargestellt sind, die freigeschnitten sind und bei einer herkömmlichen Draufsicht nicht zu erkennen wären. Aufgeführt sind in dieser Figur der Leiterbahnkontakt 61, die Leiterbahn 81, das Leiterbahnkontaktfenster 101, der Solder-Bump 111 und ein Abstand 121 zwischen Solder-Bump 111 und Chipkontakt 46.

Anhand von Fig. 1b wird deutlich, daß der Solder-Bump 111 und der Leiterbahnkontakt 61, der an derselben Stelle der hier gezeigten Fläche wie der Chipkontakt 46 angeordnet ist, zueinander um einen Abstand x versetzt sind. Der Solder-Bump 111 ist damit gegenüber dem Chipkontakt 46 versetzt angeordnet, was wiederum bewirkt, daß das Chipmodul 1 gemäß der vorliegenden Erfindung einen von dem originären Chipkontakt 46 weggeführten bzw. umverdrahteten Solder-Bump 111 aufweist.

Durch eine Variation von Konfigurationen der Leiterbahn 81 läßt sich der Abstand zwischen Solder-Bump 111 und Chipkontakt 46 verändern, wodurch auch die Anordnung der leitenden Verbindungen zwischen dem Chipmodul 1 und einem hier nicht gezeigten Träger angepaßt werden kann.

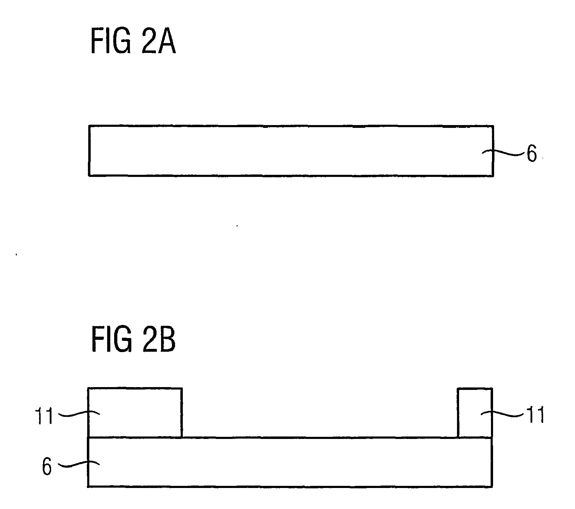

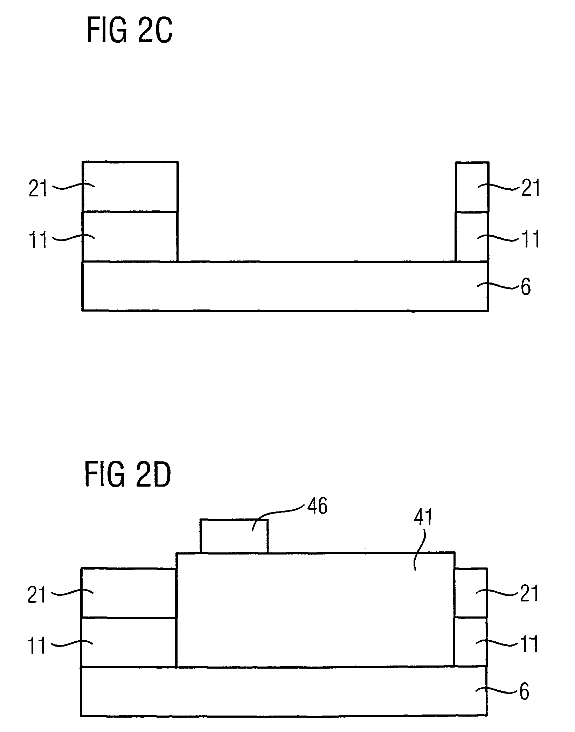

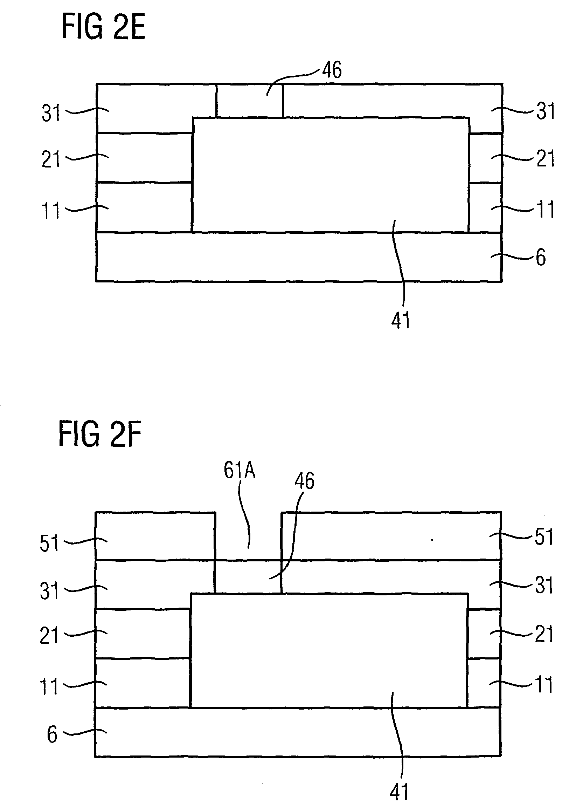

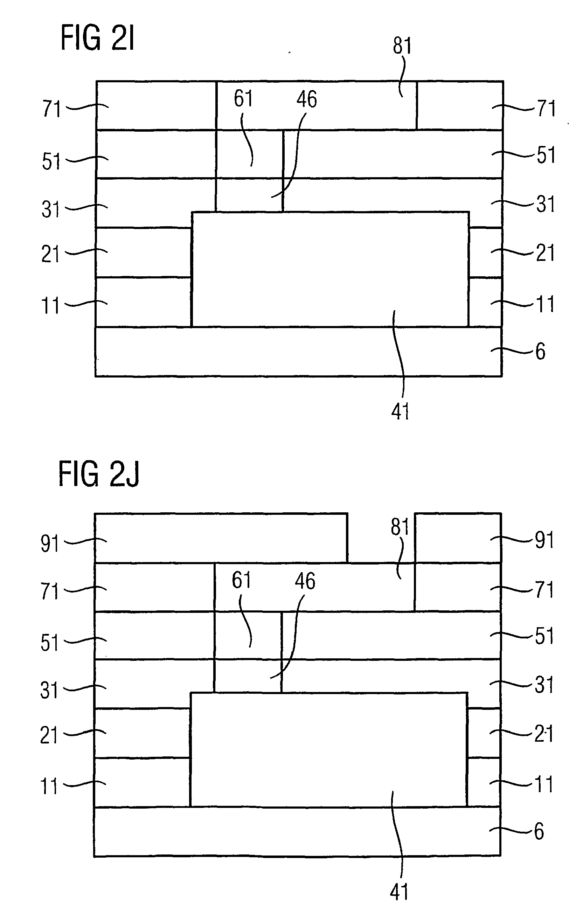

Fig. 2a - 1 zeigen aufeinander folgende Stadien während eines Herstellungsverfahrens für das Chipmodul 1 von Fig. 1a und b gemäß eines Ausführungsbeispiels der vorliegenden Erfindung. Zunächst wird wie es in Fig. 2a gezeigt ist, die erste Kunstharzschicht 6 mittels Stereolithographie angefertigt. Hierbei wird ein flüssiges Kunstharz, das zum Beispiel als Photopolymer ausgeführt sein kann, durch die Bestrahlung mit einem UV-Laser entsprechend CAD-Daten bzw. entsprechender Modelldaten ausgehärtet. Die Modelldaten definieren die Sollform der späteren isolierenden, den umverdrahteten Chip umgebenden Struktur und zwar sowohl im Hinblick auf die äußere Form als auch die Innenflächen, insbesondere die Lage und Form des Hohlraums für den Chip und die Leiterbahnverbindung. An dieser Stelle sei auch erwähnt, daß sich unterhalb der ersten Kunstharzschicht 6 weitere Kunstharzschichten befinden können, die in ähnlicher Weise angefertigt sind, jedoch hier aus Gründen der Übersichtlichkeit nicht gezeigt sind.

Danach senkt sich die in Fig. 2a gezeigte Anordnung, die sich auf einer Plattform befindet, um eine vorbestimmte Schichtdicke ab. Die nachfolgende Bildung der anderen Schichten der isolierenden Struktur wird ebenfalls mittels Stereolithographie durchgeführt. Dabei wird zunächst mittels eines Wischers ein Kunststoff an einer Oberfläche der ersten Kunstharzschicht 6 gleichmäßig verteilt. Über einen Computer wird ein beweglicher Spiegel gesteuert, wodurch der Auftreffpunkt eines über den Spiegel reflektierten Laserlichts verändert werden kann. Das Laserlicht wird dabei an dem Spiegel so reflektiert, daß das durch das Laserlicht ausgehärtete Kunstharz die zweite Kunstharzschicht 11 bildet. Auf diese Weise wird eine lokale bzw. selektive Belichtung gemäß der CAD-Daten erzielt. Die zweite Kunstharzschicht 11 weist dabei eine Ausnehmung auf, in die später noch der Chip 41 eingebracht wird.

Die so entstandene Anordnung ist in Fig. 2b gezeigt.

Fig. 2c zeigt einen nach einem weiteren Stereolithographieschritt entstandenen Mehrschichtenaufbau. Dieser umfasst eine dritte Kunstharzschicht 21, die mit einem Wischer auf der zweiten Kunstharzschicht 11 aufgebracht und anschließend mit dem Laserlicht ausgehärtet worden ist.

In einem weiteren Fertigungsschritt wird der mit dem Chipkontakt 46 versehene Chip 41 in eine Ausnehmung des Mehrschichtenaufbaus, der aus den ausgehärteten Kunstharzschichten 6, 11, 21 besteht, eingelegt.

Anschließend wird mit einem Wischer flüssiger Kunststoff, der hier ja als Photopolymer ausgeführt sein kann, auf dem mit dem Chipkontakt 46 versehenen Chip 41 und der dritten Kunstharzschicht 21 gleichmäßig verteilt. Hierbei ist zu beachten, daß der Kunstharz auch in die Lücken zwischen dem Chip 41 und den Kunstharzschichten 11, 21 eindringen kann und diese versiegeln kann. Die Lücken zwischen den Abmessungen des aus den Kunstharzschichten 6, 11, 21 bestehenden Mehrschichtenaufbaus und dem Chip 41 sind bewußt in den CAD-Daten für das Stereolithographieverfahren hinterlegt, um ein Einlegen des Chips 41 auch noch zu ermöglichen, falls die Ausnehmung aufgrund von Fertigungstoleranzen an einigen Stellen geringer ausfällt in ihren Abmessungen, als dies gemäß den Abmessungen des Chips 41 der Fall sein müßte. Anschließend wird wieder mit dem UV-Laser die vierte flüssige Kunstharzschicht 31 ausgehärtet. Wie es in Fig. 2e gezeigt ist, wird der Kunstharz der Schicht 31 selektiv so belichtet bzw. ausgehärtet, daß sich anschließend der Chipkontakt 46 in einem Loch der vierten ausgehärteten Kunstharzschicht 31 befindet, und die Kunstharzschicht 31 sich bis an eine oder mehrere der Oberflächen des Chipkontakts 46 hin erstreckt und diese berührt.

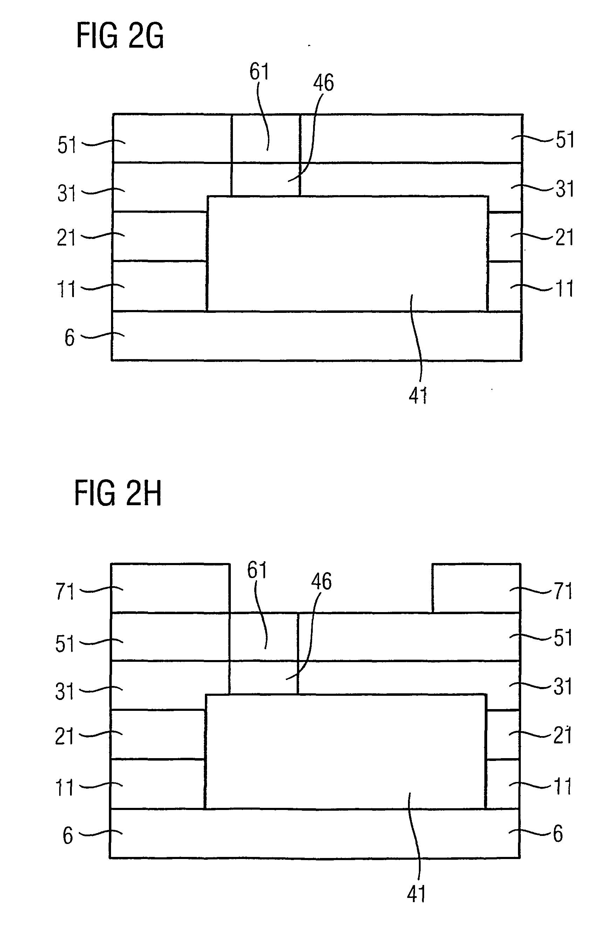

Anschließend wird in einem weiteren Herstellungsschritt eine fünfte Kunstharzschicht 51 aufgebracht, in der durch selektives Belichten gemäß der CAD-Daten eine zu dem Kontakt 46 ausgerichtete Ausnehmung (z. B. 61a) für den Leiterbahnkontakt 61 vorgesehen wird. Das Aufbringen der fünften Kunstharzschicht 51 erfolgt dabei wieder analog zu einem Aufbringen der vorhergehenden Kunstharzschichten 6, 11, 21, 31. Ein so entstandener Aufbau ist in Fig. 2g gezeigt.

Anschließend wird mittels Rakeln ein Silber-Leitkleber in die Ausnehmung in der fünften Kunstharzschicht 51 eingebracht. Danach wird der Silber-Leitkleber ausgehärtet. Der in der Ausnehmung angehäufte und ausgehärtete Silber-Leitkleber bildet den Leiterbahnkontakt 61. Ein so entstandener Aufbau ist in Fig. 2g gezeigt.

Danach wird eine sechste Kunstharzschicht 71 in analoger Weise wie die fünf darunter liegenden Kunstharzschichten 6, 11, 21, 31, 51 aufgebracht. In dieser sechsten Kunstharzschicht 71 wird eine Ausnehmung für die Leiterbahn 81 eingebracht. Die so entstandene Anordnung ist in Fig. 2h gezeigt.

Mittels eines weiteren Prozessschritts wie oben beschrieben, der u. a. einen Rakelschritt umfasst, wird die Leiterbahn 81 hergestellt, wie in Fig. 2e gezeigt. Fig. 2j zeigt einen Aufbau einer Anordnung, wie sie durch das Aufbringen der siebten Kunstharzschicht 91 erhalten worden ist. Zu erkennen ist in der siebten Kunstharzschicht 91 wiederum eine Ausnehmung, in die anschließend das Leiterbahnkontaktfenster 101 eingebracht werden soll.

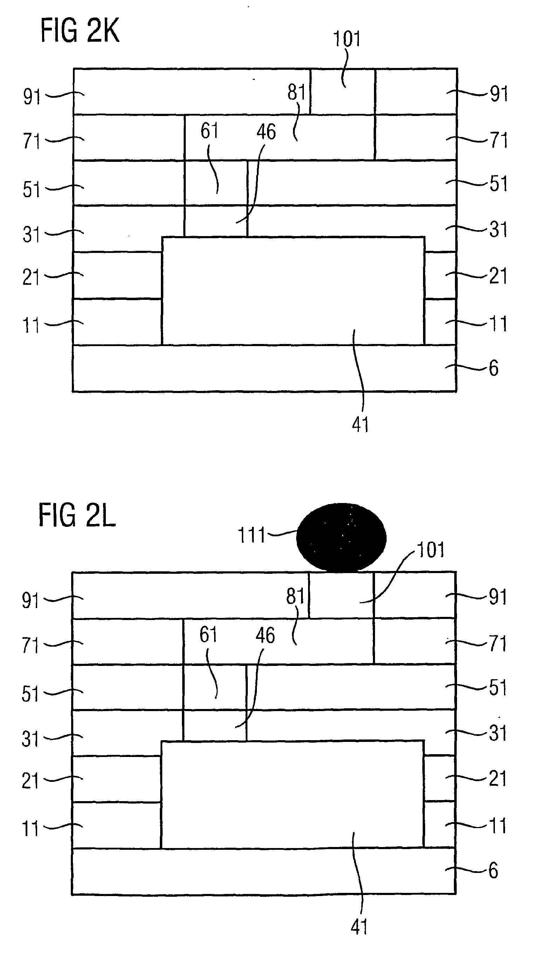

Fig. 2k zeigt die Anordnung, die aus der Fig. 2j mittels eines weiteren oben beschriebenen Prozessschritts, der u. a. einen Rakelschritt umfasst, hergestellt wurde, wobei in der Ausnehmung in der siebten Kunstharzschicht 91 wiederum mittels Rakeln ein Silber-Leitkleber eingebracht und anschließend ausgehärtet worden ist, wodurch das Leiterbahnkontaktfenster 101 entsteht.

In einem abschließenden Fertigungsschritt wird der Kontakt-Bump 111 aufgebracht wobei der Kontakt-Bump 111 mit dem Leiterbahnfenster 101 elektrisch leitend verbunden ist. Diese Anordnung ist in Fig. 2l gezeigt. Über den Solder-Bump 111 kann die in Fig. 1 gezeigte Anordnung wieder mit einem Träger elektrisch leitend und mechanisch verbunden werden.

In obigen Ausführungsbeispielen wird der Silber-Leitkleber für die leitenden Schichten 61, 81, 101 jeweils mittels Rakelns in eine Ausnehmung einer ausgehärteten Kunstharzschicht 51, 71, 91 eingebracht, die durch gleichmäßiges Verteilen auf der darunterliegenden Schicht 31, 51 bzw. 71 und durch selektives Belichten erhalten worden ist.

Alternativen sind weitere Verfahren, um ein leitendes Material oder ein Ausgangsmaterial für ein leitendes Material in der isolierenden Struktur einzubringen, bzw. aus der in Fig. 2e gezeigten Anordnung die in Fig. 2g gezeigte Anordnung zu erzeugen. Bei einer zweiten Variante kann hierzu eine Stereolithographieanlage eingesetzt werden, die zwei Becken mit unterschiedlichen Polymeren z. B. ein erstes Polymer zur Ummantelung des Chips in einem ersten Becken und ein mit einem leitfähigen Kunstharz gefülltes zweites Becken umfasst. Dazu wird nach der Fertigstellung der Schicht 51 mit dem ersten Polymer bzw. Resin das Modell aus dem ersten Becken herausgenommen, falls erforderlich gespült, und in das zweite Becken mit dem zweiten Polymer bzw. Resin getaucht, um die Kavitäten mit dem zweiten Polymer bzw. Resin restlos zu füllen. Die in Fig. 2g gezeigte Anordnung wird dann anschließend bis zur Grenzfläche zwischen den Schichten 51, 71 angehoben. Das leitfähige Resin aus dem zweiten Becken verbleibt nur in der Ausnehmung 61a oberhalb dem Chipkontakt 46 und wird dort gezielt bestrahlt bwz. ausgehärtet.

Eine weitere Alternative bzw. dritte Variante den Leiterbahnkontakt 61 in der Ausnehmung der fünften Kunstharzschicht 51 einzubringen, wäre zuerst wiederum die Ausnehmung 61a zu erzeugen, und anschließend könnte eine stromlosen Abscheidung von Nickel oder Kupfer in der Ausnehmung 61a erfolgen. Hierzu ist es vorteilhaft, wenn die Ausnehmung 61a in der fünften Kunstharzschicht 51 zuerst mit beispielsweise Palladium bekeimt wird. Anschließend wird das Metall dann auf diesen bekeimten Flächen abgeschieden. Die dabei entstehende Schichtdicke ist von der Verweildauer in einem Bad abhängig.

Oben beschriebene alternative Verfahrensschritte könnten auch für die Erzeugung der Leiterbahn 81 und des Leiterbahnkontaktfensters 101 angewendet werden. Selbstverständlich können die Varianten für die Herstellung der leitenden Verbindungen 61, 81, 101 auch untereinander gemischt werden, beispielsweise für die Herstellung des Leiterbahnkontakts die in den Ausführungsbeispielen eingesetzte Variante und für die Anfertigung der Leiterbahn 81 die Variante 2 eingesetzt werden. Vorteilhafterweise ist auf die Verträglichkeit der verschiedenen Materialien zu achten.

In dem in Fig. 1 gezeigten Chipmodul 1 ist der Solder-Bump 111 auf dem Leiterbahnkontaktfenster 101 aufgebracht. Alternativ könnte auch ein Polymer-Bump oder ein beliebiger anderer Höcker aus leitfähigem Material auf dem Leiterbahnkontaktfenster 101 aufgebracht sein, um eine mechanische und elektrisch leitende Verbindung mit einem Träger herzustellen. Er könnte gegebenenfalls auch fehlen.

In obigen Ausführungsbeispielen sind die leitenden Bereiche 61, 81, 101 mittels eines Silber-Leitklebers hergestellt worden. Alternativ sind beliebige andere leitfähige Materialien, wie zum Beispiel leitfähige Kleber für die Herstellung der leitenden Schichten einsetzbar.

In obigen Ausführungsbeispielen wird ein einziger Chipkontakt umverdrahtet. Selbstverständlich könnten in obigen Ausführungsbeispielen auch eine Mehrzahl von Chipkontakten umverdrahtet sein bzw. werden, bzw. eine Mehrzahl von Chipkontakten mit einem Ersatzkontakt verbunden werden.

In obigen Ausführungsbeispielen sind der Leiterbahnkontakt 61 und der Chipkontakt 46 vorzugsweise elektrisch leitend und mechanisch miteinander verbunden, darunter fällt auch eine Verbindung, die den Leiterbahnkontakt 61 und den Chipkontakt 46 chemisch miteinander verbindet.

Das Chipmodul in Fig. 1 zeigt ein vereinzeltes ungehäustes Halbleiterplättchen, das in verschieden halbleitenden Materialien wie beispielsweise Silizium, Germanium oder Galliumarsenid ausgeführt sein kann.

In dem Chipmodul in Fig. 1 beträgt die Anzahl der Kunstharzschichten sieben. Jedoch ist eine beliebige Anzahl an Kunstharzschichten möglich, um das Chipmodul 1 herzustellen.

In obigen Ausführungsbeispielen sind die Kunstharzschichten 6, 11, 21, 31, 51, 71, 91 als quaderförmige Schichten, die parallel zu dem Chip 41 angeordnet sind, konfiguriert. Jedoch sind beliebige Konfigurationen der Kunstharzschichten 6, 11, 31, 51, 71, 91 und auch beliebige Anordnungen, wobei die Quader auch nicht parallel zu dem Chip 41 angeordnet sein können, möglich.

Die Kunstharzschichten 6, 11, 21, 31, 51, 71, 91 dienen dazu den Chip 41 und den Chipersatzkontakt 46 elektrisch zu isolieren. Alternativen zu den Kunstharzschichten 6, 11, 21, 31, 51, 71, 91 sind Schichten aus beliebigem isolierendem Material, wie beispielsweise weitere Kunststoffarten.

Obige Ausführungsbeispiele haben gezeigt, daß mittels eines Aufbringens einer elektrisch leitenden Schicht eine Umverdrahtung bestehender ungehäuster Chips, beispielsweise Bare-Dices, ausgeführt werden kann.

Die Tatsache, daß für Umverdrahtung und Bumping früher nur Wafer-Level-Prozesse zur Verfügung standen, hat zu einem wesentlich geringeren industriellen Einsatz ungehäuster Chips geführt als erwartet, da keine Prototypingmöglichkeiten für Vorversuche bestanden. Die vorhergehenden Ausführungsbeispiele bieten demgegenüber eine Umverdrahtungstechnologie für Einzelchips, was mehr Flexibilität in der Herstellung derselben ermöglicht, und was eine Anfertigung verschiedener Prototypen erleichtert. Eine maskenlose Herstellung solcher Prototypen mit individuellem Design mittels Stereolithographie ermöglicht die Fertigung eines kostengünstigeren umverdrahteten Prototyps.

Anders ausgedrückt werden gemäß obigen Ausführungsbeispielen die Kunstharzschicht 6 und Schichten, die sich darunter befinden könnten (nicht dargestellt) mittels Stereolithographie hergestellt. Dabei härtet das flüssige Kunstharz, das als Photopolymer ausgeführt sein kann, durch die Bestrahlung mit einem UV-Laser schichtweise entsprechend der CAD-Daten aus. Anschließend senkt sich die Plattform um eine Schichtdicke ab. Der flüssige Kunststoff wird dabei an der Oberfläche durch einen Wischer gleichmäßig verteilt. Der Laser, der von einem Computer über einen beweglichen Spiegel gesteuert wird, fährt auf der neuen Schicht über die auszuhärtenden Flächen.

Obige Ausführungsbeispiele haben gezeigt, daß eine Methode zum Aufbringen einer Leiterbahn 81 dadurch gekennzeichnet ist, daß nach der Herstellung eines Blocks aus den Kunstharzschichten 6, 11, 21, 31, 51 ohne Einsatz eines Photolacks der Kontakt werkzeuglos direkt lokal aufgebracht werden kann. Eine Anfertigung einer Maske ist hierbei nicht erforderlich.

Gleichzeitig wird aus obigen Ausführungsbeispielen deutlich, daß das Aufbringen der Leiterbahn 81 mittels Herstellung einer Ausnehmung in der Kunstharzschicht 71 durch Stereolithographie erfolgen kann, und danach der Kontaktkanal, der hier als Leiterbahn ausgeführt ist, durch Rakeln eines leitfähigen Materials in das lokale Fenster, das eine Ausnehmung umfaßt, hergestellt werden kann.

Obige Ausführungsbeispiele haben außerdem gezeigt, daß zur Herstellung des gesamten elektrisch leitenden Kontaktkanals, der die Leiterbahn 81 umfaßt, der aus den Schichten 6, 11, 21, 31, 51 bestehende Block zusätzlich in einem Becken mit leitfähigem Resin, eingetaucht wird und daraufhin der gesamte elektrisch leitende Kontaktkanal, der hier als Leiterbahn 81 ausgeführt ist, lokal mittels Stereolithographie aufgebracht werden kann.

Außerdem haben obige Ausführungsbeispiele gezeigt, daß die leitfähigen Teile einer Umverdrahtung durch außenstromloses Abscheiden von metallischen Schichten gefertigt werden können.

Obige Ausführungsbeispiele haben auch gezeigt, daß vor dem Aufbringen des Kontaktkanals, der die Leiterbahn 81 umfaßt, auch noch ein Leiterbahnkontakt 61 auf dem Chipkontakt gemäß einem Verfahren nach den oben beschriebenen Ausführungsbeispielen aufgebracht werden kann.

Vorzugsweise weist der Leiterbahnkontakt 61 ähnliche Abmessungen wie der Chipkontakt 46 auf. Gemäß einem Verfahren nach obigen Ausführungsbeispielen kann ein Leiterbahnkontaktfenster 101 auf der Leiterbahn 81 aufgebracht werden. Vorteilhafterweise ist das Leiterbahnkontaktfenster 101 durch ähnliche Abmessungen wie der Kontakt-Bump 111 gekennzeichnet.

## Patentansprüche

1. Verfahren zur Herstellung eines Chipmoduls (1) mit folgenden Schritten:
Bereitstellen eines Chips (41) mit einem Chipkontakt (46);
Vorbereiten eines ersten Teils einer isolierenden Struktur (6, 11, 21, 31, 51, 71, 91), der eine Ausnehmung aufweist;
Einlegen des Chips (41) mit dem Chipkontakt (46) in die Ausnehmung des ersten Teils der isolierenden Struktur;
Erzeugen eines zweiten Teils der isolierenden Struktur (6, 11, 21, 31, 51, 71, 91) mittels eines Stereolithographieschrittes, so daß der zweite Teil der isolierenden Struktur (6, 11, 21, 31, 51, 71, 91) zumindest teilweise den Chip (41) und den Chipkontakt (46) bedeckt, wobei der Schritt des Erzeugens folgende Teilschritte aufweist:
Verteilen eines Kunstharzes auf einer freiliegenden Seite des Chips (41), so dass das Kunstharz in eine Lücke zwischen der Ausnehmung und dem Chip (41) eindringt und die Lücke versiegelt;
Belichten und Aushärten des Kunstharzes derart, dass der Chipkontakt (46) sich in einem Loch einer ausgehärteten Kunstharzschicht befindet;
Bilden einer Leiterbahn (61, 81, 101), die mit dem Chipkontakt (46) in dem Loch der ausgehärteten Kunstharzschicht elektrisch leitend verbunden ist; und
Aufbringen eines Ersatzkontakts (111) an der Außenoberfläche der isolierenden Struktur (91), so dass der Ersatzkontakt (101) durch die Leiterbahn (81, 101, 61) mit dem Chipkontakt (46) elektrisch leitend verbunden ist;
wobei der Schritt des Bildens einer Leiterbahn (61, 81, 101) folgende weitere Teilschritte aufweist:
Versehen des zweiten Teils der isolierenden Struktur (6, 11, 21, 31, 51, 71, 91) mit einer Ausnehmung; und
Einbringen eines leitfähigen Materials in zumindest einem Teil der Ausnehmung mittels Rakelns, um zumindest einen Teil der Leiterbahn (61, 81, 101) zu bilden.

2. Verfahren zur Herstellung eines Chipmoduls (1) gemäß Anspruch 1, bei dem der Chip (41) ein ungehäustes vereinzeltes Waferstück ist.

3. Verfahren zur Herstellung eines Chipmoduls (1) gemäß Anspruch 1 oder 2, bei dem der Schritt des Erzeugens der isolierenden Struktur (6, 11, 21, 31, 51, 71, 91) einen Schritt des Aushärtens umfaßt.

4. Verfahren zur Herstellung eines Chipmoduls (1) gemäß einem der Ansprüche 1 bis 3, bei dem der Schritt des Einbringens des leitfähigen Materials ein zumindest teilweises Eintauchen der isolierenden Struktur (6, 11, 21, 31, 51, 71, 91) in ein mit dem leitfähigen Material oder einem dem leitfähigen Material zugrundeliegenden Material gefülltes Becken umfaßt.

5. Verfahren zur Herstellung eines Chipmoduls (1) gemäß einem der Ansprüche 1 bis 4, bei dem der Schritt des Erzeugens der isolierenden Struktur (6, 11, 21, 31, 51, 71, 91) folgende Schritte aufweist:
Bereitstellen zumindest eines Teils der isolierenden Struktur (6, 11, 21, 31, 51, 71, 91), so daß der Teil der isolierenden Struktur (6, 11, 21, 31, 51, 71, 91) zumindest teilweise den Chip (41) oder den Chipkontakt (46) bedeckt;
Bekeimen eines Teils einer Außenoberfläche des Teils der isolierenden Struktur (51); und
Eintauchen des Teils der isolierenden Struktur (6,11, 21, 31, 51, 71, 91) in ein das leitfähige Material oder ein dem leitfähigen Material zugrundeliegendes Material umfassendes Material;
wobei der Chip (41) eine integrierte Schaltung aufweist, die mit dem Chipkontakt (46) gekoppelt ist.

6. Verfahren zur Herstellung eines Chipmoduls gemäß Anspruch 5, bei dem der Schritt des Eintauchens des Teils der isolierenden Struktur (6, 11, 21, 31, 51, 71, 91) ein stromloses Abscheiden eines leitfähigen Materials oder ein dem leitfähigen Material zugrundeliegendes Material umfasst.

## Claims

1. Method for producing a chip module (1), comprising:
providing a chip (41) with a chip contact (46);
preparing a first part of an insulating structure (6, 11, 21, 31, 51, 71, 91) having a recess;
introducing the chip (41) with the chip contact (46) into the recess of the first part of the insulating structure;
generating a second part of the insulating structure (6, 11, 21, 31, 51, 71, 91) by means of a stereolithography step, so that the second part of the insulating structure (6, 11, 21, 31, 51, 71, 91) covers the chip (41) and the chip contact (46) at least partly, wherein the step of generating comprises the following substeps:
distributing a synthetic resin on an exposed side of the chip (41), so that the synthetic resin penetrates into a gap between the recess and the chip (41) and seals the gap;
exposing and curing the synthetic resin such that the chip contact (46) is in a hole of a cured synthetic resin layer;
forming a conductive trace (61, 81, 101), which is connected to the chip contact (46) in the hole of the cured synthetic resin layer in an electrically conductive way; and
depositing a spare contact (111) on the external surface of the insulating structure (91), so that the spare contact (101) is connected to the chip contact (46) via the conductive trace (81, 101, 61) in an electrically conductive way;
wherein the step of forming a conductive trace (81, 101, 61) comprises the following further sub-steps:
providing the second part of the insulating structure (6, 11, 21, 31, 51, 71, 91) with a recess; and
introducing a conductive material into at least part of the recess by means of doctoring to form at least part of the conductive trace (61, 81, 101).

2. Method for producing a chip module (I) according to claim 1, wherein the chip (41) is an unhoused diced wafer piece.

3. Method for producing a chip module (1) according to claim 1 or 2, wherein the step of generating the insulating structure (6, 11, 21, 31, 51, 71, 91) comprises a step of curing.

4. Method for producing a chip module (1) according to one of claims 1 to 3, wherein the step of introducing the conductive material comprises at least partly dipping the insulating structure (6, 11, 21, 31, 51, 71, 91) into a basin filled with the conductive material or a material underlying the conductive material.

5. Method for producing a chip module (1) according to one of claims 1 to 4, wherein the step of generating the insulating structure (6, 11, 21, 31, 51, 71, 91) comprises the steps of:
providing at least part of the insulating structure (6, 11, 21, 31, 51, 71, 91), so that the part of the insulating structure (6, 11, 21, 31, 51, 71, 91) covers the chip (41) or the chip contact (46) at least partly;
seeding part of an external surface of the part of the insulating structure (51); and
dipping the part of the insulating structure (6, 11, 21, 31, 51, 71, 91) into a material comprising the conductive material or a material underlying the conductive material;
wherein the chip (41) comprises an integrated circuit coupled to the chip contact (46).

6. Method for producing a chip module according to claim 5, wherein the step of dipping the part of the insulating structure (6, 11, 21, 31, 51, 71, 91) comprises currentless depositing of a conductive material or a material underlying the conductive material.

## Revendications

1. Procédé de fabrication d'un module à puce (1), aux étapes suivantes consistant à:
préparer une puce (41) avec un contact de puce (46);
préparer une première partie d'une structure isolante (6, 11, 21, 31, 51, 71, 91) présentant un évidement;
placer la puce (41) avec le contact de puce (46) dans l'évidement de la première partie de la structure isolante;
générer une deuxième partie de la structure isolante (6, 11, 21, 31, 51, 71, 91) au moyen d'une étape stéréolithographique, de sorte que la deuxième partie de la structure isolante (6, 11, 21, 31, 51, 71, 91) recouvre au moins partiellement la puce (41) et le contact de puce (46), l'étape de génération présente les étapes partielles suivantes consistant à:
répartir une résine synthétique sur la face libre de la puce (41), de sorte que la résine synthétique pénètre dans un interstice entre l'évidement et la puce (41) et obture l'interstice;
éclairer et durcir la résine synthétique de sorte que le contact de puce (46) se situe dans un trou d'une couche de résine synthétique durcie;
former un ruban conducteur (61, 81, 101) qui est relié de manière électroconductrice avec le contact de puce (46) dans le trou de la couche de résine synthétique durcie; et
appliquer un contact de réserve (11) sur la surface extérieure de la structure isolante (91), de sorte que le contact de réserve (101) soit relié, par le ruban conducteur (81, 101, 61), de manière électroconductrice avec le contact de puce (46);
l'étape de formation d'un ruban conducteur (61, 81, 101) présentant les autres étapes partielles suivantes consistant à:
pourvoir la deuxième partie de la structure isolante (6, 11, 21, 31, 51,71,91) d'un évidement; et
introduire par raclage un matériau conducteur dans au moins une partie de l'évidement, pour former au moins une partie du ruban conducteur (61, 81, 101).

2. Procédé de fabrication d'un module à puce (1) selon la revendication 1, dans lequel la puce (41) est une pièce de plaquette séparée sans boîtier.

3. Procédé de fabrication d'un module à puce (1) selon la revendication 1 ou 2, dans lequel l'étape de génération de la structure isolante (6, 11, 21, 31, 51, 71, 91) comporte une étape de durcissement.

4. Procédé de fabrication d'un module à puce (1) selon l'une des revendications 1 à 3, dans lequel l'étape d'introduction du matériau conducteur comporte une immersion au moins partielle de la structure isolante (6, 11, 21, 31, 51, 71, 91) dans un bassin rempli du matériau conducteur ou d'un matériau à la base du matériau conducteur.

5. Procédé de fabrication d'un module à puce (1) selon l'une des revendications 1 à 4, dans lequel l'étape de génération de structure isolante (6, 11, 21, 31, 51, 71, 91) présente les étapes suivantes consistant à:
préparer au moins une partie de la structure isolante (6, 11, 21, 31, 51, 71, 91), de sorte que la partie de la structure isolante (6, 11, 21, 31, 51, 71, 91) recouvre au moins partiellement la puce (41) ou le contact de puce (46);
germer une partie d'une surface extérieure de la partie de la structure isolante (51); et
plonger la partie de la structure isolante (6, 11, 21, 31, 51, 71, 91) dans un matériau comprenant le matériau conducteur ou un matériau à la base du matériau conducteur;
la puce (41) présentant un circuit intégré qui est couplé au contact de puce (46).

6. Procédé de fabrication d'un module à puce selon la revendication 5, dans lequel l'étape d'immersion de la partie de la structure isolante (6, 11, 21, 31, 51, 71, 91) comprend un dépôt sans courant d'un matériau conducteur ou d'un matériau à la base du matériau conducteur.
